Europäisches Patentamt

**European Patent Office**

**Office européen des brevets**

(19)

(11) Numéro de publication : **0 018 862**

**B1**

(12)

# FASCICULE DE BREVET EUROPÉEN

(45) Date de publication du fascicule du brevet :
26.09.84

(21) Numéro de dépôt : 80400420.8

(22) Date de dépôt : 28.03.80

(51) Int. Cl.³ : **H 01 L 29/90**

(54) **Diode à avalanche de type planar à tension de claquage comprise entre 4 et 8 volts et procédé de fabrication.**

(30) Priorité : 20.04.79 FR 7910065

(43) Date de publication de la demande :
12.11.80 Bulletin 80/23

(45) Mention de la délivrance du brevet :
26.09.84 Bulletin 84/39

(84) Etats contractants désignés :
**DE GB IT NL**

(56) Documents cités :
**DE-A- 2 649 935**
**IEEE TRANSACTIONS ON ELECTRON DEVICES, vol. ED-23, mai 1976, no. 5, New York, US R.B. FAIR et al. "Zener and avalanche breakdown in As-implanted low-voltage Si n-p junctions", pages 512-518**

(73) Titulaire : **THOMSON-CSF**
**173, Boulevard Haussmann**
**F-75379 Paris Cedex 08 (FR)**

(72) Inventeur : **Valdman, Henri**
**"THOMSON-CSF" SCPI - 173, Bld Haussmann**
**F-75360 Paris Cedex 08 (FR)**

(74) Mandataire : **de Beaumont, Michel et al**
**THOMSON-CSF SCPI 173, Bld Haussmann**
**F-75379 Paris Cedex 08 (FR)**

## Description

La présente invention concerne une nouvelle structure de diode à avalanche de type planar et plus particulièrement de telles diodes ayant une tension de claquage comprise entre 4 et 8 volts.

On rappellera que le claquage des diodes dépend en fait de deux phénomènes physiques distincts. Dans le domaine des faibles tensions de claquage (inférieures à 4 volts), il se produit un effet Zener, c'est-à-dire une transition des électrons de valence dans la bande de conduction sous l'effet d'un champ électrique très élevé. Dans le domaine des plus fortes tensions (supérieures à 8 volts) il se produit un effet d'avalanche par multiplication des porteurs dans la zone de charge d'espace. On devrait donc parler de façon distincte de diode Zener ou de diode à avalanche d'un point de vue théorique. Dans la pratique, ces diodes sont indifféremment désignées par le terme diode Zener ou le terme diode à avalanche indépendamment du phénomène physique mis en œuvre. Par exemple, la tension de claquage est généralement désignée par la référence $V_z$ qui fait normalement référence à l'effet Zener, même dans le cas où il se produit en fait un effet d'avalanche.

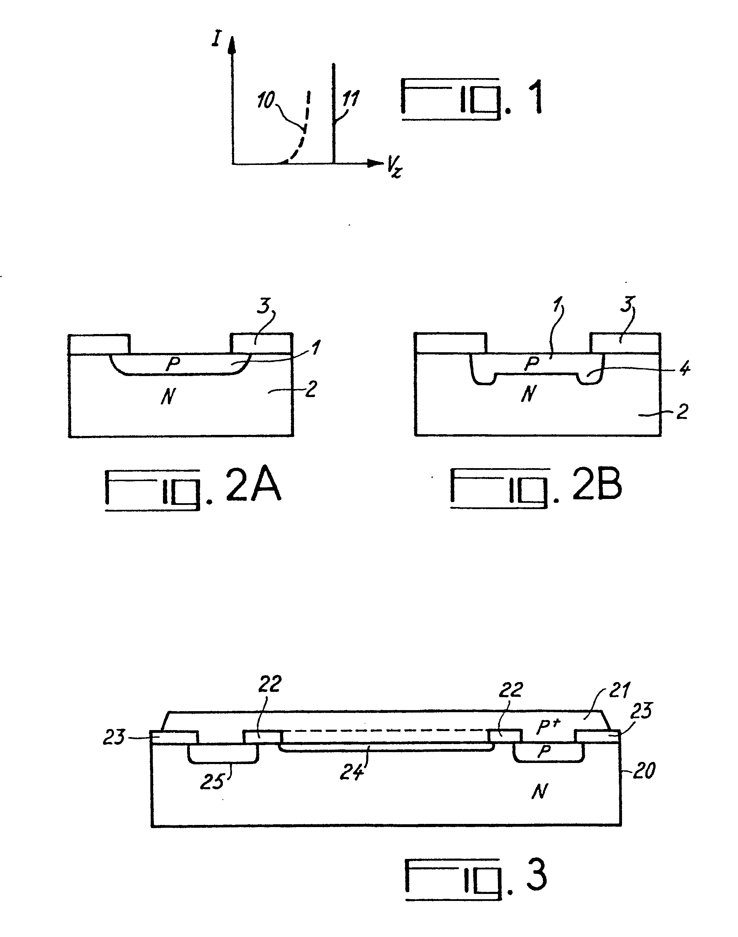

La figure 1 représente en pointillés une courbe 10 caractéristique d'une diode à effet Zener de tension de seuil par exemple inférieure à 4 volts et, en trait plein, une courbe 11 caractéristique d'une diode à effet d'avalanche à tension de claquage par exemple supérieure à 8 volts. On notera que, de façon générale, la courbe caractéristique d'une diode fonctionnant par effet d'avalanche présente un coude très marqué et une faible impédance dynamique $R_{ZK}$ au voisinage du coude. Par contre, pour une diode fonctionnant en effet Zener, on a pour des raisons inhérentes à l'effet Zener, une caractéristique présentant un coude relativement arrondi, c'est-à-dire une plus forte impédance dynamique.

On s'intéressera ici plus particulièrement aux diodes Zener dont la tension de claquage est intermédiaire entre 4 et 8 volts. Dans ce domaine l'effet physique en cause est partiellement un effet Zener, partiellement un effet d'avalanche et, selon les modes de construction, on obtient des caractéristiques de claquage à coude plus ou moins arrondi.

Les figures 2A et 2B représentent deux structures classiques de diodes Zener planar selon l'art antérieur. La figure 2A représente une diode Zener planar simple dans laquelle une diffusion P, 1, est formée dans un substrat N, 2, par l'intermédiaire d'un masque d'oxyde de silicium 3 ménageant une fenêtre à travers laquelle est faite la diffusion. En utilisant cette structure, on obtient, dans la plage de tension concernée, des diodes Zener à coude relativement nettement marqué. Néanmoins, ces diodes présentent l'inconvénient que les caractéristiques sont variables en fonction de la durée d'utilisation, c'est-à-dire qu'en fonction du temps le coude s'arrondit, la tension de claquage peut varier et le courant inverse augmente.

Pour pallier cet inconvénient, on a utilisé dans l'art antérieur la structure représentée en figure 2B dans laquelle la diffusion P, 1, représentée en figure 2A est entourée d'une zone 4 à diffusion P plus profonde. Cette structure est couramment appelée structure à anneau de garde. On constate que, pour des diodes à anneau de garde telles que représentées en figure 2B, la fiabilité est bien meilleure que dans le cas des diodes représentées en figure 2A, c'est-à-dire que les caractéristiques initiales se maintiennent en fonction du temps ; mais, par contre, ces diodes à anneau de garde présentent une caractéristique de claquage à coude nettement plus arrondi que les diodes sans anneau de garde telles que représentées en figure 2A.

On se trouve donc dans la pratique confronté à faire l'un ou l'autre de deux mauvais choix entre une diode à bonne caractéristique initiale mais mauvaise fiabilité et une diode à bonne fiabilité mais à caractéristique de claquage peu satisfaisante.

Ainsi un objet de la présente invention est de prévoir, pour le domaine de tension allant sensiblement de 4 à 8 volts, une nouvelle structure de diode Zener permettant de pallier les inconvénients de l'art antérieur, c'est-à-dire de cumuler les avantages d'une caractéristique d'allure satisfaisante et d'une bonne fiabilité.

Selon la présente invention, il est prévu une diode à avalanche, de type planar, à anneau de garde, et à tension de claquage comprise entre 4 et 8 volts comprenant un substrat de silicium d'un premier type de conductivité dans lequel une zone est délimitée par un anneau de garde du deuxième type de conductivité, la plus grande partie de ladite zone étant occupée par une couche du second type de conductivité moins profonde que l'anneau de garde, le substrat affleurant dans la région restante de ladite zone, cette région étant recouverte d'une couche isolante et d'au moins une couche de protection étanche vis-à-vis de produits contaminants tels que des ions alcalins et enfermant complètement ladite couche isolante.

La couche isolante pourra être une couche de silice qui peut être elle-même protégée par un film de nitrure de silicium afin d'améliorer son étanchéité vis-à-vis des contaminants.

La couche de protection peut notamment être constituée d'une couche épitaxiée, ou tout simplement de dépôts métalliques de prise de connexion.

On va d'abord exposer quelques considérations théoriques permettant d'expliquer la présente invention en tenant compte du fait que la structure revendiquée ci-après s'est avérée fonctionner de façon satisfaisante et qu'une inexactitude dans l'exposé théorique des phénomènes ne saurait nuire à la brevetabilité de l'invention, ces explications n'étant données qu'à titre indicatif.

Quand on considère la structure de la figure 2A, et plus particulièrement la jonction entre les couches P et N, on notera que cette jonction comprend une région centrale qui a une tension de claquage $V_{ZC}$ et une région latérale de rayon de courbure r et qui a une tension de claquage $V_{ZL}$ avec $V_{ZL} < V_{ZC}$ (on peut estimer que $V_{ZC}$-$V_{ZL}$ est compris entre 200 et 700 mV pour une diode de 6 V). Le claquage d'une telle jonction apparaît d'abord dans la zone latérale ou zone courbe de la jonction. Il en résulte que le claquage à bas niveau se produit dans cette zone périphérique de très petite section, constante d'un échantillon à un autre, et que les défauts de structure sont masqués. Par suite, l'impédance dynamique à bas niveau $R_{ZK}$ est faible et peu dispersée d'un échantillon à un autre, c'est-à-dire que le coude de la caractéristique est nettement marqué.

Dans le cas de la figure 2B, la diode comprend encore la région centrale de tension de claquage $V_{ZC}$ mais l'anneau de garde a cette fois une tension de claquage $V_{ZG}$ supérieure à $V_{ZC}$. On peut constater expérimentalement que le claquage des jonctions avec anneau de garde apparaît dans la zone centrale et s'étend progressivement dans toute la zone quand le courant augmente. L'avalanche est non uniforme en raison des défauts de structure de la jonction difficiles à éviter (dopage hétérogène du substrat, concentration hétérogène du dopant et dislocations induites par la diffusion). On obtient donc un coude relativement arrondi. L'aire de la jonction concernée par l'avalanche à bas niveau est toujours inférieure à l'aire de la zone centrale, mais elle est variable d'un échantillon à un autre.

La demanderesse s'est également penchée sur les raisons qui entraînent le défaut de fiabilité des diodes sans anneau de garde. De l'avis de la demanderesse, l'une des raisons principales réside dans le fait que des ions alcalins sont introduits, par exemple au moment du montage de la diode, dans la couche de silice 3. Au cours du fonctionnement de la diode, ces ions alcalins migrent progressivement depuis la périphérie vers la zone où affleure la jonction et modifient la répartition de la charge d'espace et donc la tension de claquage initiale de la diode. Cette explication permet également d'exposer de façon cohérente pourquoi les caractéristiques d'une diode à anneau de garde sont relativement fiables. En effet, dans ce cas, même si des ions alcalins migrent dans la couche de silice 3 vers la zone où affleure la jonction sur la surface du corps semiconducteur, cette migration des ions est sans influence sur le claquage étant donné que ce n'est pas la zone voisine de l'affleurement de jonction qui détermine le début de l'avalanche, cette avalanche débutant comme on l'a exposé précédemment au voisinage de la région centrale d'une diode à anneau de garde classique.

Cette influence des ions alcalins est connue notamment à partir de la demande de brevet français 1 515 678. L'idée de protéger la surface de couche d'oxyde pour éviter la pénétration d'ions alcalins se trouve également dans la demande de brevet français 2 019 679 et dans l'article de J. C. Sarace et al. paru dans Solid-State Electronics 1968, Vol. 11, pages 653 à 660. Néanmoins, dans ces documents, la couche d'oxyde présente une face latérale découverte à partir de laquelle peuvent pénétrer des impuretés notamment lors de l'encapsulation. L'invention évite cet inconvénient.

Ces objets, caractéristiques et avantages de la présente invention ainsi que d'autres seront exposés ci-après en relation avec des modes de réalisation particuliers et les figures jointes parmi lesquelles :

la figure 1 représente diverses formes de caractéristiques courant-tension de diodes Zener ;

les figures 2A et 2B représentent des diodes Zener planar selon l'art antérieur ;

la figure 3 représente un premier mode de réalisation de diode Zener selon la présente invention ;

la figure 4 représente un second mode de réalisation de diode Zener selon la présente invention ; et

les figures 5 et 6 représentent des vues de dessus de diode Zener selon divers modes de réalisation de la présente invention.

Tout d'abord, on notera de façon générale que, comme cela est usuel dans le domaine des semiconducteurs, les figures ne sont pas représentées à l'échelle mais que certaines de leurs parties ont été dilatées pour faciliter la lecture et la compréhension.

La figure 3 représente une diode de type épitaxié comprenant un substrat 20 de type N sur lequel est formé par croissance épitaxiale une couche de type $P^+$21, cette couche $P^+$ entraînant la formation, par diffusion à travers un masque comprenant un premier anneau 22 et un deuxième anneau 23, d'une zone de diffusion centrale 24 et d'une zone de diffusion périphérique 25. La diffusion périphérique correspond à un anneau de garde. Pour ce faire, il convient d'avoir prévu, avant la formation de la couche épitaxiée, une diffusion préalable correspondant à l'anneau 25 en utilisant un masque tel que représenté en pointillés couvrant toute la surface centrale de la diode. La distance latérale entre les couches 24 et 25 est supérieure à l'épaisseur de la zone de charge d'espace. Dans le domaine de tension considéré, l'épaisseur de la zone de charge d'espace peut être de l'ordre de 0,1 micron. Par contre, la distance latérale entre les bords des diffusions 24 et 25 sera supérieure à 10 microns.

Avec la diode de la figure 3, après les diverses métallisations et lors du montage, une pollution du masque de silice périphérique 23 pourra se produire à partir de l'extérieur mais le masque 22 qui se trouve recouvert par la couche épitaxiée et éventuellement par les couches de métallisation ultérieures ne peut être contaminé.

Ainsi, en considérant les explications théoriques données précédemment, le claquage de la diode intervient au niveau des bords de la couche 24 comme dans le cas d'une diode sans anneau de garde représentée en figure 2A. On obtient donc une caractéristique à coude nettement marqué (c'est-à-dire peu arrondi) et cette caractéristique est fiable dans le temps étant donné que la couche de silice 22 ne peut être polluée par des ions alcalins susceptibles d'y migrer. Néanmoins, même si l'explication théorique donnée est inexacte, l'expérience montre bien que la diode représentée en figure 3 présente à la fois une bonne caractéristique tension-courant et une bonne fiabilité dans le temps.

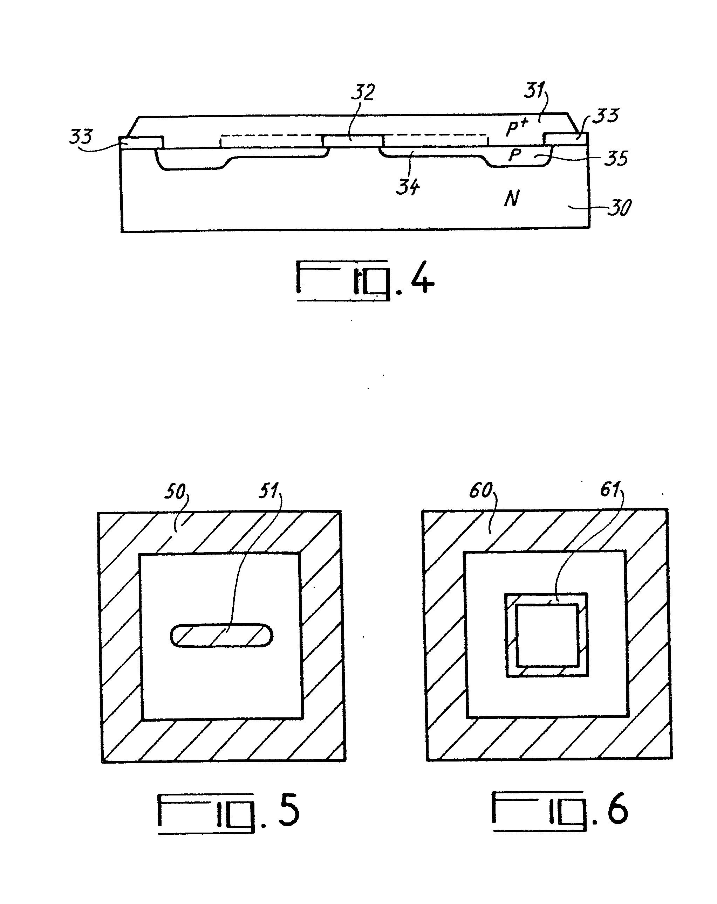

La figure 4 illustre une deuxième variante de réalisation de la présente invention. On peut y avoir une diode Zener comprenant un substrat 30, une couche épitaxiée 31 et un masque de diffusion comprenant un îlot central 32 et un anneau latéral 33. La couche épitaxiée 31 est amenée à entraîner une diffusion de son dopant dans le substrat pour former une couche diffusée 34. Comme dans le cas de la figure 3, avant la formation de la couche épitaxiée 31, une prédiffusion a été effectuée dans le substrat 30 pour former un anneau diffusé 35 de type de conductivité opposé à celui du substrat. Le masque pour former cette première diffusion de l'anneau de garde est illustré en pointillé en figure 4. A nouveau, les résultats escomptés de la présente invention ont été observés sur un dispositif tel que représenté en figure 4.

La figure 5 représente une vue de dessus d'un masque d'oxyde destiné à obtenir une structure du type de celle de la figure 4, ce masque comprend un anneau de silice périphérique 50 (on emploi le terme anneau au sens large, pour désigner une surface fermée continue entourant la diode selon son périmètre qui, dans le cas représenté ; est de forme carrée) et un îlot central 51. L'îlot central a été représenté sous forme d'une bande allongée. Il pourra être de forme circulaire, cruciforme, en étoile ou digité, selon le cas.

La forme précise des îlots et leurs dimensions doivent être compatibles avec les conditions suivantes :

— Coude bien marqué à bas niveau de courant,

— Bonne impédance dynamique à fort courant,

— Tenue en surcharge peu ou pas affectée par la présence de l'îlot.

Pour ce dernier point, la surface occupée par l'îlot doit être minimisée. Dans les cas où les îlots se présentent sous la forme des figures 5 et 6, la largeur des doigts est inférieure ou égale à 10 μ et leur longueur, de l'ordre de 50 à 200 μ, est fonction du niveau de courant d'utilisation.

La figure 6 représente en vue de dessus un autre mode de réalisation de masque d'oxyde pour la fabrication d'une diode selon la présente invention. Ce masque comprend à nouveau un anneau périphérique 60 et comprend cette fois un anneau de plus faible diamètre 61 (on notera en relation avec la figure qu'à nouveau les termes anneau et diamètre sont utilisés au sens large). Cet anneau 61 pourra se trouver à la limite de l'anneau de garde pour correspondre au cas de la figure 3 ou encore être d'un diamètre inférieur.

Les modes de réalisation particuliers décrits précédemment l'ont été dans le cas de diodes à structure épitaxiée, mais la présente invention s'applique également à des diodes de type planar ne comprenant pas de couche épitaxiée. En ce cas, la protection du masque de silice interne (îlot 51 ou anneau 61) est assurée par les couches de métallisation, par exemple en Al, Cr, Ni ou Ag, destinées à venir prendre le contact sur la diode. D'autre part, les anneaux de garde pourraient être formés autrement que par diffusion, par exemple par implantation.

Bien entendu, dans la description précédente, les types de conductivité N et P pourront être interchangés.

**Revendications**

1. Diode à avalanche, de type planar, à anneau de garde, et à tension de claquage comprise entre 4 et 8 volts comprenant un substrat (20, 30) de silicium d'un premier type de conductivité dans lequel une zone est délimitée par un anneau de garde (25, 35) du deuxième type de conductivité, caractérisée en ce que la plus grande partie de ladite zone est occupée par une couche du second type de conductivité (24, 34) moins profonde que l'anneau de garde, le substrat affleurant dans la région restante de ladite zone, cette région étant recouverte d'une couche isolante (22, 32) et d'au moins une couche de protection (21, 31) étanche vis-à-vis de produits contaminants tels que des ions alcalins et enfermant complètement ladite couche isolante.

2. Diode selon la revendication 1, caractérisée en ce que la couche isolante est une couche d'oxyde.

3. Diode selon l'une des revendications 1 ou 2, caractérisée en ce que la couche de protection comprend une couche épitaxiée du deuxième type de conductivité.

4. Diode selon l'une des revendications 1 ou 2, caractérisée en ce que la couche de protection comprend une couche de métallisation.

5. Diode selon l'une quelconque des revendications 1 à 4, caractérisée en ce que ladite région a la forme d'un anneau.

6. Diode selon l'une quelconque des revendications 1 à 4, caractérisée en ce que ladite région a la forme d'un îlot central.

7. Diode selon l'une quelconque des revendications 1 à 4, caractérisée en ce que ladite région a une forme digitée.

8. Procédé de fabrication d'une diode à avalanche de type planar à tension de claquage comprise entre 4 et 8 volts à partir d'un substrat de silicium d'un premier type de conductivité consistant à former dans ce substrat un anneau périphérique (25, 35) de diffusion profonde, caractérisé en ce qu'il comprend les étapes suivantes :

— diffuser à l'intérieur du périmètre délimité par la diffusion profonde une couche (24, 34) de même type de conductivité mais de moindre profondeur en réservant à l'aide d'un masque d'oxyde (22, 32) une région de ce périmètre en dessous de laquelle aucune diffusion n'est effectuée,

— recouvrir la couche d'oxyde sur au moins ladite région d'une couche supplémentaire (21, 31) enfermant complètement ladite couche d'oxyde.

9. Procédé selon la revendication 8, caractérisé en ce que la diffusion de la couche de moindre profondeur est formée à partir d'une couche épitaxiée (21, 31) déposée sur la surface du substrat au-dessus dudit masque.

## Claims

1. A planar avalanche diode having a guard ring and a breakdown voltage between 4 and 8 Volt, incorporating a silicon substrate (20, 30) of a first conductivity type, in which a zone is delimited by a guard ring (25, 35) of the second conductivity type, characterized in that the major part of said zone is occupied by a layer of the second conductivity type (24, 34), which is less deep than the guard ring, the substrate appearing in the remaining region of said zone, this region being covered by an insulating layer (22, 32) and at least one protective layer (21, 31) which is impervious to contaminating products such as alkali ions and which completely encases said insulating layer.

2. A diode according to claim 1, characterized in that the insulating layer is an oxide layer.

3. A diode according to one of claims 1 or 2, characterized in that the protective layer comprises an epitaxial layer of the second conductivity type.

4. A diode according to one of the claims 1 or 2, characterized in that the protective layer comprises a metallisation layer.

5. A diode according to any one of claims 1 to 4, characterized in that said region is ringshaped.

6. A diode according to any one of claims 1 to 4, characterized in that said region is shaped like a central island.

7. A diode according to any one of claims 1 to 4, characterized in that the region is finger-shaped.

8. A method for the manufacture of a planar avalanche diode, the breakdown voltage of which is comprised between 4 and 8 Volt, from a silicon substrate of a first conductivity type, this method comprising the constitution of a peripheral ring (25, 35) of a deep diffusion in this substrate, characterized in that it comprises the following steps :

— providing by diffusion a layer (24, 34) of the same conductivity type but of a smaller depth inside the perimeter which is delimited by the deep diffusion whilst reserving by means of an oxide mask (22, 32) a region inside said perimeter below which no diffusion at all is effected,

— covering the oxide layer on at least said region by a supplementary layer (21, 31) which encases completely said oxide layer.

9. A method according to claim 8, characterized in that the diffusion of the less deep layer is formed from an epitaxial layer (21, 31) deposited on the substrate surface above said mask.

## Ansprüche

1. Planare Avalanche-Diode mit Sperring, deren Durchbruch-Spannung zwischen 4 und 8 Volt liegt, mit einem Silizium-substrat (20, 30) eines ersten Leitfähigkeitstyps, in dem eine Zone durch einen Sperring (25, 35) eines zweiten Leitfähigkeitstyps begrenzt ist, dadurch gekennzeichnet, daß der größte Teil dieser Zone von einer weniger tiefen Schicht des zweiten Leiffähigkeitstyps (24, 34) als der des Sperrings besetzt ist und daß das Substrat in dem restlichen Bereich dieser Zone zutagetritt, wobei dieser Bereich mit einer Isolierschicht (22, 32) und mindestens einer Schutzschicht (21, 31) bedeckt ist, die bezüglich kontaminierender Stoffe, wie alkalische Ionen, dicht ist und die Isolierschicht ganz einschließt.

2. Diode nach Anspruch 1, dadurch gekennzeichnet, daß die Isolierschicht eine Oxidschicht ist.

3. Diode nach einem der Ansprüche 1 oder 2, dadurch gekennzeichnet, daß die Schitzschicht eine Epitaxialschicht des zweiten Leitfähigkeitstyps enthält.

4. Diode nach einem der Ansprüche 1 oder 2, dadurch gekennzeichnet, daß die Schutzschicht eine Metallisationsschicht enthält.

5. Diode nach einem beliebigen der Ansprüche 1 bis 4, dadurch gekennzeichnet, daß der Bereich Ringform aufweist.

6. Diode nach einem beliebigen der Ansprüche 1 bis 4, dadurch gekennzeichnet, daß der Bereich die Form einer zentralen Insel aufweist.

7. Diode nach einem beliebigen der Ansprüche 1 bis 4, dadurch gekennzeichnet, daß der Bereich eine Fingerform aufweist.

8. Verfahren zur Herstellung einer planaren Avalanche-Diode, deren Durchbruchspannung zwischen 4 und 8 Volt liegt, ausgehend von einem Siliziumsubstrat eines ersten Leitfähigkeitstyps, wobei in diesem Substrat ein peripherer Ring (25, 35) tiefer Diffusion gebildet wird, dadurch gekennzeichnet, daß es folgende Verfahrensschritte aufweist :

— eine Schicht (24, 34) desselben Leitfähigkeitstyps, aber geringerer Tiefe wird durch Diffusion im Inneren des durch die tiefe Diffusion begrenzten Areals erzeugt, wobei mithilfe einer Oxidmaske (22, 32) ein Bereich in diesem Areal ausgespart bleibt, in dem gar keine Diffusion erfolgt,

— die Oxidschicht wird mindestens in diesem Bereich mit einer zusätzlichen Schicht (21, 31) bedeckt, die die Oxidschicht ganz einschließt.

9. Verfahren nach Anspruch 8, dadurch gekennzeichnet, daß die Diffusion der Schicht geringerer Tiefe ausgehend von einer Epitaxialschicht erfolgt, die auf die Oberfläche des Substrats oberhalb der Maske aufgebracht wird.

FIg. 1

FIg. 2A

FIg. 2B

FIg. 3

Fig.4

Fig.5

Fig.6